Europäisches Patentamt

(19) European Patent Office

Office européen des brevets

(11) **EP 0 469 626 B1**

(12) **EUROPEAN PATENT SPECIFICATION**

(45) Date of publication and mention
of the grant of the patent:
**29.04.1998 Bulletin 1998/18**

(51) Int. Cl.$^6$: **C01B 31/06**, C23C 16/26

(21) Application number: **91113034.2**

(22) Date of filing: **02.08.1991**

(54) **Chemical vapor deposition method of high quality diamond**

CVD-Verfahren zur Herstellung von Diamant

Méthode de dépot chimique en phase vapeur de diamant de haute qualité

(84) Designated Contracting States:
**DE FR GB NL**

(30) Priority: **03.08.1990 JP 206976/90**
**09.08.1990 JP 211015/90**
**09.08.1990 JP 211016/90**
**22.08.1990 JP 222262/90**

(43) Date of publication of application:
**05.02.1992 Bulletin 1992/06**

(73) Proprietor:
**SUMITOMO ELECTRIC INDUSTRIES, LTD.**
**Osaka-shi, Osaka 541 (JP)**

(72) Inventors:
• **Fujimori, Naoji,**
**c/o Itami Works**
**Itami-shi, Hyogo-ken (JP)**
• **Ikegaya, Akihiko,**
**c/o Itami Works**
**Itami-shi, Hyogo-ken (JP)**
• **Imai, Takahiro,**
**c/o Itami Works**
**Itami-shi, Hyogo-ken (JP)**

• **Ota, Nobuhiro,**
**c/o Itami Works**
**Itami-shi, Hyogo-ken (JP)**
• **Shibata, Takayuki**
**Otaru-shi, Hokkido (JP)**

(74) Representative:
**Hansen, Bernd, Dr. Dipl.-Chem. et al**
**Hoffmann Eitle,**
**Patent- und Rechtsanwälte,**
**Postfach 81 04 20**
**81904 München (DE)**

(56) References cited:
**EP-A- 0 288 065        EP-A- 0 327 051**
**EP-A- 0 376 694        US-A- 4 434 188**

• **PATENT ABSTRACTS OF JAPAN vol. 11, no. 267**
**(C-443)(2714), 28 August 1987**
• **APPLIED PHYSICS LETTERS vol. 57, no. 14, 1**
**October 1990, pages 1467-1469, New York, US;**
**ZHANG et al.: "In situ observations of optical**
**emission spectra in the diamond deposition**
**environment of arc discharge plasma chemical**
**vapor deposition"**

Printed by Xerox (UK) Business Services
2.16.1/3.4

**Description**

BACKGROUND OF THE INVENTION

Field of the Invention

The present invention relates to a chemical vapor deposition method of high quality diamond. More particularly, the present invention relates to a method for producing a diamond which is substantially free from non-diamond carbon such as amorphous carbon or graphite by chemical vapor deposition (CVD).

Description of the Related Art

Diamond has high hardness, good abrasion resistance, a small compressibility, a small coefficient of thermal expansion and a very large coefficient of thermal conductivity though it is an insulator. In addition, diamond has a large refractive index and optical transparency to UV, visible and IR light as well as chemical resistance. In diamond, sonic wave is transmitted at a high velocity of propagation. Further, addition of a specific impurity can impart semiconductive characteristics to the diamond. Therefore, application of diamond is sought in various technical fields, and now diamond is one of indispensable materials in recent technology.

For example, by making use of the large thermal conductivity, a diamond layer or film is used as a heat sink with high performance for a high output IC or a laser diode.

To synthesize diamond, a super high pressure method and a chemical vapor deposition method are known. The super high pressure method comprises synthesizing diamond from a carbon source in a metal solvent such as iron under super high pressure at high temperature. Since a size of each produced diamond particle is rather small, this method cannot produce a sufficiently large diamond particle for the heat sink which requires a size of several mm to several cm square. Further, since impurity elements from the metal solvent contaminate diamond inevitably, the coefficient of thermal conductivity has a limit. Diamond produced by this method has a coefficient of thermal conductivity of about 22 W/cm.K which is substantially the same as that of IIa type natural diamond, and no diamond having a larger coefficient of thermal conductivity has been produced by this method.

In the CVD method, a raw material gas containing a carbon source and hydrogen is decomposed and activated and diamond is deposited in the form of a film or plate on a substrate. Since the deposition area can be made larger than several cm square, a production cost is low. Various CVD methods have been developed according to difference of means for decomposition and activation of the raw material gas. Among them, a hot filament CVD which uses a heating filament to be heated at high temperature and a plasma CVD which uses microwave plasma or DC thermal plasma are typical.

The diamond film synthesized by any CVD method has a coefficient of thermal conductivity of 16 W/cm.K or less, which is smaller than that of natural diamond or diamond synthesized by the super high pressure catalytic method.

EP-A 0 376 694 discloses a process for the vapor phase synthesis of diamond and describes highly crystalline diamond with a thermal conductivity up to 14.0 Watt/cm x K and a Raman peak height ratio of 0.05.

In the CVD method, in general, the raw material gas contains methane as the carbon source and hydrogen, though other carbon compounds such as acetylene, benzene, ethanol and acetone may be used as the carbon source. It is known that the addition of a small amount of a gas containing oxygen (e.g. oxygen, carbon monoxide, carbon dioxide, etc.) to the raw material gas will increase properties of deposited diamond.

EP-A-0 288 065 relates to a CVD method for synthesis of diamond which comprises contacting a gas obtained by excitation of carbon monoxide and hydrogen with a substrate. It is not disclosed how to control the concentration of nitrogen gas in relation to the whole reaction gas.

Diamond which is synthesized by the CVD method contains a non-diamond carbon such as amorphous carbon or graphite. Hitherto, no clear relationship among the amounts of hydrogen, carbon and oxygen atoms has been established for the production of diamond which is substantially free from the non-diamond carbon. Further, it is very difficult to avoid contamination of nitrogen which is contained in air in a large amount, even though a reaction system is made as close as possible to an ideal system for the synthesis of diamond.

SUMMARY OF THE INVENTION

One object of the present invention is to establish a relationship among hydrogen, carbon, oxygen and optionally nitrogen for the synthesis of high quality diamond by a CVD method.

Another object of the present invention is to provide a method for producing diamond which is free from non-diamond carbon by a CVD method.

A further object of the present invention is to provide a method for producing diamond which contains nitrogen in a very small amount by a CVD method.

A yet another object of the present invention is to provide diamond having a large coefficient of thermal conductivity by a CVD method.

According to the present invention, there is provided a method for producing diamond by a CVD method comprising decomposing and reacting a reaction gas

wherein $\alpha$ is smaller than or equal to 13 and B is greater than or equal to 20 or

whereby (B ppm) is the concentration of nitrogen gas in relation to the whole reaction gas and $\alpha$ is defined by the equation:

$$\alpha = \sqrt{B} \times (A - 1.2C)$$

in which (A %) is the concentration of carbon atoms in relation to hydrogen gas and (C %) is the concentration of oxygen atoms in relation to the hydrogen gas.

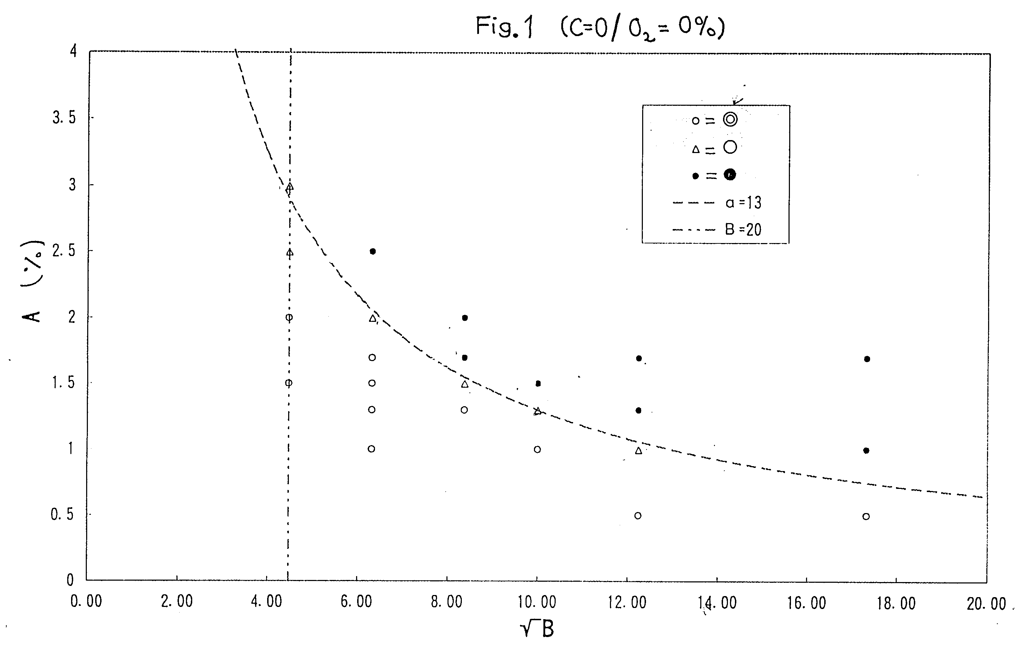

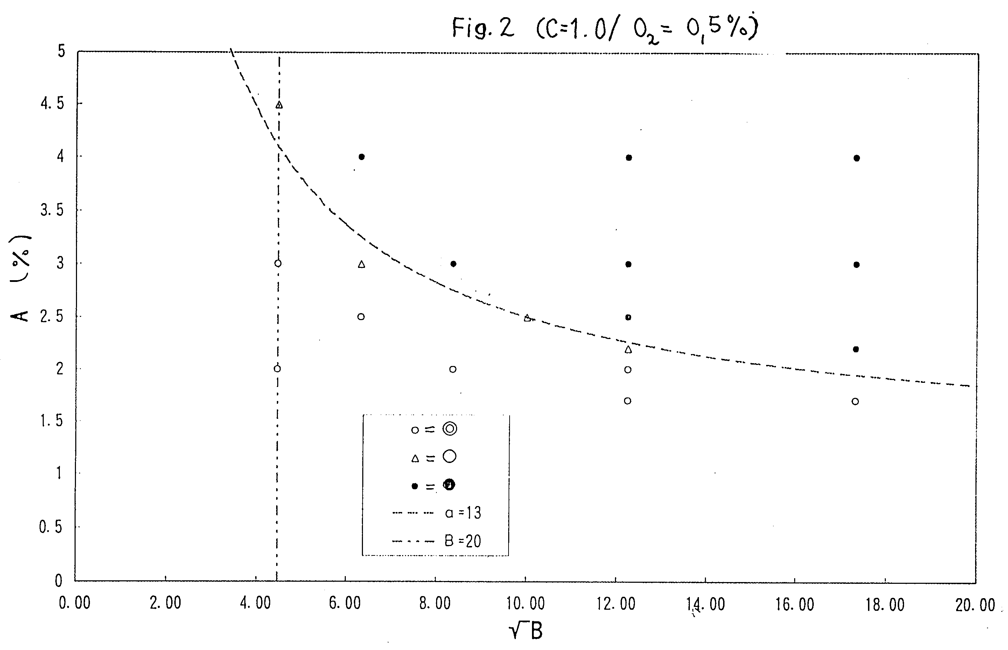

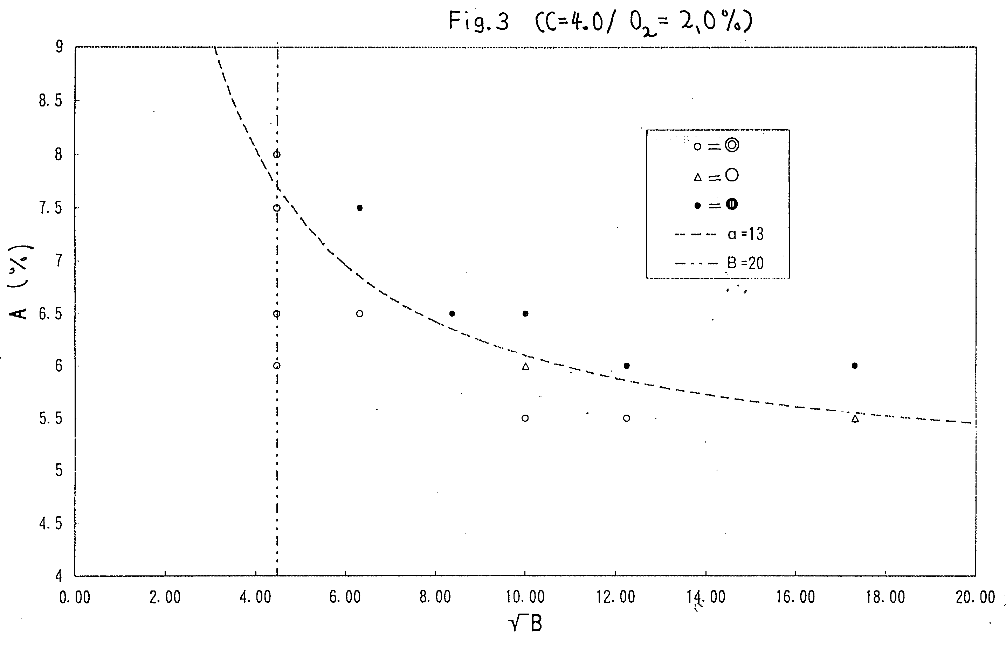

Figs. 1, 2 and 3 are graphs plotting the quality of the diamond films synthesized in Examples 1 and 2.

DETAILED DESCRIPTION OF THE DRAWINGS

In the process of the present invention, the diamond film is deposited on a substrate in the same manner as in the conventional CVD method except that the concentration of the raw materials are selected to satisfy the above conditions $\alpha \leq 13$ and B (nitrogen conc. in ppm) $\geq 20$.

In one embodiment of the present invention, the carbon atoms contained in the reaction gas comprises 99.9 % or more of $^{12}C$ or $^{13}C$, and synthesized diamond contains 20 ppm or less, preferably 5 ppm or less of nitrogen atoms. Thereby, the diamond film has a large coefficient of thermal conductivity of at least 25 W/cm.K. In view of the phonon energy, $^{12}C$ is preferred.

Carbon comprising 99.9 % or more of $^{12}C$ or $^{13}C$ may be obtained by mass separation of a conventional carbon source such as methane, ethane, acetylene, an alcohol, a ketone, carbon monoxide, carbon dioxide, etc.

Herein, the term "substantially free from the non-diamond carbon" intends to mean that, in the Raman spectroscopic spectrum, a ratio of a peak height of non-diamond carbon to that of diamond is not larger than 0.07, preferably not larger than 0.05.

When a filament made of carbon, in particular carbon comprising 99.9 % or more of $^{12}C$ or $^{13}C$ is used as a filament to be used in the hot filament CVD method, contamination of synthesized diamond with metal impurities generated from a metal filament such as W, Ta, Re, etc. can be prevented. As the carbon filament, one made of amorphous carbon, graphite or carbon composite may be used.

The present invention will be illustrated by the following examples.

Example 1

Diamond was synthesized by the conventional microwave plasma CVD using, as a reaction gas, a mixture of hydrogen gas (purity of 7 N) and methane gas (purity of 6 N) or a mixture of hydrogen gas (purity of 7 N), methane gas (purity of 6 N) and nitrogen gas.

With varying the concentration of the methane gas in relation to the hydrogen gas and the concentration of the nitrogen gas in relation to the whole reaction gas, diamond was synthesized. The conditions are shown in Table 1. In Table 1, the $\alpha$ value is indicated when B was larger than 20. For comparison, the $\alpha$ is indicated in the brackets when B was 20.

The diamond film quality was evaluated by Raman spectroscopy which is effective to detect the non-diamond carbon as follows:

In the Raman spectroscopy, a ratio of the maximum height of a broad peak of the non-diamond carbon which appears from 1350 to 1600 $cm^{-1}$ to the peak height of diamond around 1333 $cm^{-1}$ is calculated and ranked according to the following criteria:

◎ :   Less than 0.1.
○ :   From 0.1 to 0.3.
● :   Larger than 0.3.

As understood from the results in Table 1, when the methane gas concentration was constant, the quality of the diamond film was quickly deteriorated as the nitrogen gas concentration was increased, and the diamond film was black which was seen by naked eyes (Quality ranking ●).

When the nitrogen gas concentration in the reaction gas was high, the deterioration of the diamond quality was prevented by the decrease of the methane gas concentration.

Table 1

| Sample No. | Concentration | | | α | Quality of diamond film |
|---|---|---|---|---|---|
| | CH$_4$ (%) | O$_2$ (%) | N$_2$ (B ppm) | | |
| 1 | 0.5 | 0 | 150 | 6.1 | ◎ |
| 2 | ↑ | ↑ | 300 | 8.7 | ◎ |
| 3 | ↑ | ↑ | 40 | 6.3 | ◎ |
| 4 | ↑ | ↑ | 100 | 10.0 | ◎ |
| 5 | ↑ | ↑ | 150 | 12.2 | ○ |
| 6 | ↑ | ↑ | 300 | 17.3 | ● |
| 7 | 1.3 | ↑ | 40 | 8.2 | ◎ |
| 8 | ↑ | ↑ | 70 | 10.9 | ◎ |
| 9 | ↑ | ↑ | 100 | 13.0 | ○ |
| 10 | ↑ | ↑ | 150 | 15.9 | ● |
| 11 | 1.5 | ↑ | 20 | (6.7) | ◎ |
| 12 | ↑ | ↑ | 40 | 9.5 | ◎ |
| 13 | ↑ | ↑ | 70 | 12.5 | ○ |
| 14 | ↑ | ↑ | 100 | 15.0 | ● |
| 15 | 1.7 | ↑ | 40 | 10.8 | ◎ |
| 16 | ↑ | ↑ | 70 | 14.2 | ● |
| 17 | ↑ | ↑ | 150 | 20.8 | ● |
| 18 | ↑ | ↑ | 300 | 29.4 | ● |
| 19 | 2.0 | ↑ | 20 | (8.9) | ◎ |
| 20 | ↑ | ↑ | 40 | 12.6 | ○ |
| 21 | ↑ | ↑ | 70 | 16.7 | ● |
| 22 | 2.5 | ↑ | 20 | (11.2) | ○ |
| 23 | ↑ | ↑ | 40 | 15.8 | ● |

Example 2

In the same manner as in Example 1 but changing the composition of the reaction gas as shown in Tables 2 and 3, the diamond was synthesized and its quality was evaluated. The results are shown in Tables 2 and 3, which relate to the cases where 0.5 % and 2.0 % of the oxygen gas was used in relation to the hydrogen gas, respectively.

These results show that the increase of the nitrogen gas concentration in the reaction gas has influence on the diamond film quality.

When the oxygen gas was added, the carbon gas concentration at which the film quality starts to decrease was lower than in the case where no oxygen gas was added, and such carbon gas concentration increases as the oxygen gas concentration increases.

In case where the oxygen gas was added, when the nitrogen gas concentration was less than 20 ppm, there was no difference in the Raman spectroscopy and SEM observation.

Table 2

| Sample No. | Concentration | | | α | Quality of diamond film |
|---|---|---|---|---|---|
| | $CH_4$ (%) | $O_2$ (%) | $N_2$ (B ppm) | | |
| 24 | 1.7 | 0.5 | 150 | 6.1 | ◎ |
| 25 | ↑ | ↑ | 300 | 8.7 | ◎ |
| 26 | 2.0 | ↑ | 20 | (3.6) | ◎ |
| 27 | ↑ | ↑ | 70 | 6.7 | ◎ |
| 28 | ↑ | ↑ | 150 | 9.8 | ◎ |
| 29 | 2.2 | ↑ | 150 | 12.2 | ○ |
| 30 | ↑ | ↑ | 300 | 17.3 | ● |
| 31 | 2.5 | ↑ | 40 | 6.3 | ◎ |
| 32 | ↑ | ↑ | 100 | 13.0 | ○ |
| 33 | ↑ | ↑ | 150 | 15.9 | ● |
| 34 | 3.0 | ↑ | 20 | (8.0) | ◎ |
| 35 | ↑ | ↑ | 40 | 11.4 | ◎ |
| 36 | ↑ | ↑ | 70 | 15.1 | ● |
| 37 | ↑ | ↑ | 150 | 22.0 | ● |
| 38 | ↑ | ↑ | 300 | 31.2 | ● |
| 39 | 4.0 | ↑ | 40 | 17.7 | ● |
| 40 | ↑ | ↑ | 150 | 34.4 | ● |
| 41 | ↑ | ↑ | 300 | 48.5 | ● |

Table 3

| Sample No. | Concentration | | | $\alpha$ | Quality of diamond film |
|---|---|---|---|---|---|
| | CH$_4$ (%) | O$_2$ (%) | N$_2$ (B ppm) | | |
| 42 | 5.5 | 2.0 | 100 | 7.0 | ◎ |
| 43 | ↑ | ↑ | 150 | 8.6 | ◎ |
| 44 | ↑ | ↑ | 300 | 12.1 | ○ |
| 45 | 6.0 | ↑ | 20 | (5.4) | ◎ |
| 46 | ↑ | ↑ | 100 | 12.0 | ○ |
| 47 | ↑ | ↑ | 150 | 14.7 | ● |
| 48 | ↑ | ↑ | 300 | 20.8 | ● |
| 49 | 6.5 | ↑ | 20 | (7.6) | ◎ |
| 50 | ↑ | ↑ | 40 | 10.8 | ◎ |
| 51 | ↑ | ↑ | 70 | 14.2 | ● |
| 52 | ↑ | ↑ | 100 | 17.0 | ● |
| 53 | 7.5 | ↑ | 20 | (12.1) | ◎ |
| 54 | ↑ | ↑ | 40 | 17.0 | ● |

The film quality in Tables 1, 2 and 3 are plotted in Figs. 1, 2 and 3 with B being on the abscissa and A being on the ordinate. In figures, the dotted curve and the dotted line correspond to $\alpha = \sqrt{B} \times (A - 1.2C) = 13$ and B = 20, respectively.

From these figures, it is understood that when the concentrations of the components in the reaction gas satisfy the above equation (I), the diamond film has good quality.

Example 3

In the same manner as in Example 1 but using methane, acetylene, benzene, ethanol or acetone as a carbon source, oxygen, carbon monoxide or carbon dioxide as an oxygen source and nitrogen in concentrations shown in Table 4, a diamond film was deposited.

When the concentrations of the raw materials satisfy the conditions as to $\alpha$ and B, the diamond film had good quality.

Table 4

| Sample No. | Concentration | | | α | Quality of diamond film |
|---|---|---|---|---|---|
| | Carbon source | Oxygen source (%) | N$_2$ (B ppm) | | |
| 55 | CH$_4$ (2.0) | CO (1.0) | 40 | 11.4 | ○ |
| 56 | ↑ | ↑ | 100 | 18.0 | ● |
| 57 | C$_2$H$_2$ (3.5) | O$_2$ (2.0) | 20 | (9.8) | ◎ |
| 58 | ↑ | ↑ | 50 | 15.6 | ● |
| 59 | C$_6$H$_6$ (0.5) | CO$_2$ (1.0) | 100 | 16.0 | ● |
| 60 | C$_2$H$_5$OH (2.0) | -- | 50 | 11.3 | ○ |
| 61 | ↑ | -- | 70 | 13.4 | ● |
| 62 | (CH$_3$)CO (1.0) | CO (0.5) | 30 | 9.3 | ○ |
| 63 | ↑ | ↑ | 50 | 12.0 | ◎ |
| 64 | ↑ | ↑ | 70 | 14.2 | ● |

## Example 4

A diamond film was synthesized by the conventional microwave plasma CVD using a methane gas containing 99.95 % of [12]C. Purities of methane and hydrogen were 99.9999 % and 99.99999 %, respectively.

An amount of the nitrogen gas contained in the reaction gas was precisely measured by gas chromatography to find that it was 8 ppm. At a ratio of methane and hydrogen of 1:100, the diamond film having a thickness of about 500 μm was deposited in 500 hours on a silicon wafer a surface of which was abrased with diamond powder.

After removing the substrate with an acid, the diamond film was abrased to a thickness of 300 μm.

The coefficient of thermal conductivity of this film was 30 W/cm.K.

## Example 5

In the same manner as in Example 4 but changing the content of $^{12}$C in the methane gas, a diamond film was synthesized. The coefficient of thermal conductivity was as follows:

| Content of $^{12}$C (%) | Coefficient of thermal conductivity |
|---|---|
| 99 | 16 |
| 99.5 | 16 |
| 99.8 | 18 |
| 99.9 | 25 |
| 99.92 | 29 |
| 99.95 | 30 |
| 99.99 | 33.5 |

## Example 6

In the same manner as in Example 4 but changing the nitrogen gas concentration, a diamond film was synthesized. The coefficient of thermal conductivity was as follows:

| Nitrogen content (ppm) | Coefficient of thermal conductivity |
|---|---|
| 1 | 34 |
| 5 | 33 |
| 8 | 30 |
| 10 | 30 |
| 12 | 30 |
| 15 | 28 |
| 20 | 25 |
| 25 | 18 |
| 30 | 11 |
| 40 | 8 |

Example 7

A diamond film was synthesized by the conventional hot filament CVD using a methane gas containing 99.92 % of $^{12}C$. As the filament, a tungsten wire of 0.2 mm in diameter was used and heated at 2080°C. The substrate temperature was kept at 950°C.

The nitrogen content in the reaction gas was 10 ppm. At the methane concentration of 1.2 %, diamond was deposited for 600 hours to obtain a diamond film having a thickness of 450 μm.

After removing the substrate with an acid, the diamond film was abrased to a thickness of 300 μm.

The coefficient of thermal conductivity of this film was 25 W/cm.K.

Example 8

A diamond film was deposited by the conventional microwave plasma CVD using a methane gas containing 99.95 % of $^{12}C$ and hydrogen on a silicon wafer (20 mm square) which had been abrased with #5000 diamond abrasive.

The nitrogen content in the reaction gas was 20 ppm by the gas chromatography analysis.

The diamond was deposited on the wafer using a reaction gas containing methane and hydrogen in a ratio of 1:100 under an reactor pressure of 400 Torr, at a microwave output of 400 W, at a substrate temperature of 950°C for 500 hours to obtain a diamond film having a thickness of about 500 μm.

After removing the substrate wafer with hydrofluoric acid to recover the diamond thin film, and both surfaces of the diamond film were abrased to a thickness of 300 μm.

The composition of the diamond film was analyzed by a coupled apparatus of thermal decomposition gas chromatograph and mass spectroscopy to find that the content of $^{12}C$ was 99.95 % and the content of nitrogen was 5 ppm.

According to the Raman spectroscopy, a peak height ratio of the non-diamond carbon to diamond was 0.03.

The coefficient of thermal conductivity of the diamond film was measured by comparing a temperature gradient at a constant heat flux with a known diamond sample. It was 30 W/cm.K.

Example 9

In the same manner as in Example 8 but changing the ratio of methane to hydrogen and the substrate temperature, a diamond film was synthesized.

The quality of the diamond film was evaluated in the same manner as in Example 8. The contents of $^{12}C$ and nitrogen were the same as the diamond film obtained in Example 8, and the peak height ratio of the non-diamond carbon to diamond and the coefficient of thermal conductivity were as shown in Table 5.

Table 5

| Sample No. | Peak height ratio of non-diamond carbon to diamond | Coefficient of thermal conductivity (W/cm.K) |
|---|---|---|
| 101 | 0.01 | 33 |
| 102 | 0.03 | 30 |
| 103 | 0.07 | 25 |
| 104 | 0.10 | 16 |
| 105 | 0.15 | 9 |

Example 10

In the same manner as in Example 8 but changing the content of $^{12}C$ in methane, a diamond film was synthesized.
The quality of the diamond film was evaluated in the same manner as in Example 1. The peak height ratio of the non-diamond carbon to diamond was the same as in Example 1. The content of $^{12}C$ in the diamond film was the same as in methane. The relationship between the content of $^{12}C$ to the coefficient of thermal conductivity is shown in Table 6.

Table 6

| Sample No. | Content of $^{12}C$ in diamond (%) | Coefficient of thermal conductivity (W/cm.K) |
|---|---|---|
| 106 | 99.00 | 16 |
| 107 | 99.50 | 16 |
| 108 | 99.80 | 18 |
| 109 | 99.90 | 25 |
| 110 | 99.92 | 29 |
| 111 | 99.95 | 30 |
| 112 | 99.99 | 33 |

Example 11

In the same manner as in Example 8 but changing the content of $^{12}C$ in methane to 99.9 % and the content of nitrogen in the reaction gas as shown in Table 7, the diamond film was synthesized.
The quality of the diamond film was evaluated in the same manner as in Example 8. The content of $^{12}C$ in the diamond film was 99.9 %, and the peak height ratio of the non-diamond carbon to diamond was the same as in Example 8. The relationship between the nitrogen contents in the reaction gas and the diamond film and the coefficient of thermal conductivity is shown in Table 7.

Table 7

| Sample No. | N content in reaction gas (ppm) | N content in diamond film (ppm) | Coefficient of thermal conductivity (W/cm.K) |
|---|---|---|---|
| 113 | 1 | 0.2 | 34 |
| 114 | 5 | 1 | 33 |
| 115 | 8 | 2 | 30 |
| 116 | 10 | 3 | 30 |
| 117 | 12 | 3 | 30 |
| 118 | 15 | 4 | 28 |
| 119 | 20 | 5 | 25 |
| 120 | 25 | 7 | 18 |
| 121 | 30 | 8 | 11 |
| 122 | 40 | 10 | 8 |

Example 12

A diamond film was deposited by the conventional hot filament CVD (W filament having a diameter of 0.2 mm) using a methane gas containing 99.92 % of $^{12}$C and hydrogen on a silicon wafer (4 inch square) which had been abrased in the same manner as in Example 8.

The nitrogen content in the reaction gas was 50 ppm by the gas chromatography analysis.

The diamond was deposited on the wafer using a reaction gas containing methane and hydrogen in a ratio of 1.2:100 under an reactor pressure of 40 Torr, at a filament temperature of 2080°C, at a substrate temperature of 950°C for 600 hours to obtain a diamond film having a thickness of about 450 $\mu$m.

After removing the substrate wafer with hydrofluoric acid to recover the diamond thin film, and both surfaces of the diamond film were abrased to a thickness of 300 $\mu$m.

The composition of the diamond film was analyzed by a coupled apparatus of thermal decomposition gas chromatograph and mass spectroscopy to find that the content of $^{12}$C was 99.92 % and the content of nitrogen was 3 ppm.

According to the-Raman spectroscopy, a peak height ratio of the non-diamond carbon to diamond was 0.03.

The coefficient of thermal conductivity of the diamond film was 25 W/cm.K.

Example 13

A diamond film was deposited by the conventional hot filament plasma CVD using a graphite filament containing 99.9 % of $^{12}$C on a silicon wafer (10 mm square, and 3 mm thick) which had been abrased with #5000 diamond abrasive.

After evacuating a reactor chamber to 1 x 10$^{-6}$ Torr, methane containing 99.5 % of $^{12}$C and hydrogen were supplied in the reactor at flow rates of 10 sccm and 500 sccm, respectively. The nitrogen content in the reaction gas was less than 1 ppm by the gas chromatography analysis.

The diamond was deposited on the wafer for 150 hours by heating the filament which was placed at a distance of 8 mm from the wafer surface at 2100°C, adjusting the wafer temperature at 950, keeping the interior pressure at 150 Torr. to obtain a diamond film having a thickness of about 0.5 mm.

After removing the substrate wafer with hydrofluoric acid to recover the diamond thin film, and both surfaces of the diamond film were abrased to a thickness of 0.3 mm with a surface roughness $R_{max}$ of 0.03 $\mu$m.

Non-diamond carbon was not found in the diamond film by the Raman spectroscopy.

The coefficient of thermal conductivity of the diamond film was measured by comparing a temperature gradient at a constant heat flux with a known diamond sample. It was 34 W/cm.K.

Example 14

In the same manner as in Example 13 but changing the contents of $^{12}$C in the graphite filament, $^{12}$C in methane and nitrogen in the reaction gas as shown in Table 8, a diamond film was synthesized.

After polishing the diamond film to a thickness of 0.3 mm and $R_{max}$ of 0.04 $\mu$m, the coefficient of thermal conductivity was measured. The results are shown in Table 8.

Table 8

| Sample No. | $^{12}C$ content in graphite (%) | $^{12}C$ content in methane (%) | N content in reaction gas (ppm) | Coefficient of thermal conductivity (W/cm.K) |
|---|---|---|---|---|
| 123 | 99.0 | 99.9 | 1 | 18 |
| 124 | 99.5 | 99.9 | 1 | 21 |
| 125 | 99.9 | 99.9 | 1 | 26 |
| 126 | 99.95 | 99.9 | 1 | 28 |
| 127 | 99.99 | 99.9 | 1 | 30 |
| 128 | 99.9 | 99.0 | 1 | 16 |
| 129 | 99.9 | 99.5 | 1 | 18 |
| 130 | 99.9 | 99.9 | 1 | 26 |
| 131 | 99.9 | 99.95 | 1 | 32 |
| 132 | 99.9 | 99.99 | 1 | 35 |
| 133 | 99.9 | 99.95 | 5 | 30 |
| 134 | 99.9 | 99.95 | 10 | 28 |
| 135 | 99.9 | 99.95 | 15 | 27 |
| 136 | 99.9 | 99.95 | 20 | 25 |
| 137 | 99.9 | 99.95 | 25 | 17 |

**Claims**

1. A method for producing diamond by a CVD method comprising decomposing and reacting a reaction gas wherein $\alpha$ is smaller than or equal to 13 and B is greater than or equal to 20 whereby (B ppm) is the concentration of nitrogen gas in relation to the whole reaction gas and $\alpha$ is defined by the equation:

$$\alpha = \sqrt{B} \times (A - 1.2C)$$

   in which (A %) is the concentration of carbon atoms in relation to hydrogen gas and (C %) is the concentration of oxygen atoms in relation to the hydrogen gas.

2. The method according to claim 1, wherein said carbon atoms in said reaction gas comprise 99.9 % or more of $12_C$ or $13_C$.

3. The method according to claim 2, wherein said carbon atoms in said reaction gas comprise 99.9 % or more of $12_C$.

4. The method according to claim 1, wherein at least one compound selected from the group consisting of methane, ethane, acetylene, an alcohol, a ketone, carbon monoxide and carbon dioxide is used as a carbon source.

5. The method according to claim 1, wherein the CVD method is a hot filament CVD method and the filament is a carbon filament containing 99.9 % or more of $12_C$ or $13_C$.

6. A synthetic diamond which contains 20 ppm or less of nitrogen atoms wherein the ratio of the peak heights of non-diamond carbon to that of diamond in the Raman spectroscopic spectrum is not larger than 0.07, characterized by a coefficient of thermal conductivity of at least 25 W/cmK.

7. The synthetic diamond according to claim 6 wherein said diamond contains 5 ppm or less of nitrogen atoms.

8. The synthetic diamond according to claim 6 wherein carbon comprises at least 99.9 % of $12_C$ or $13_C$ and the nitrogen content is less than 20 ppm.

## Patentansprüche

1. Verfahren zum Herstellen von Diamant durch eine CVD-Methode, das das Zerlegen und das Reagieren eines Reaktionsgases umfaßt,
bei dem $\alpha$ kleiner oder gleich 13 und B größer oder gleich 20 ist,
wobei B (ppm) die Konzentration von Stickstoff im Verhältnis zum gesamten Reaktionsgas ist und $\alpha$ definiert ist durch die Gleichung:

$$\alpha = \sqrt{B} \times (A-1,2C),$$

in der A (%) die Konzentration der Kohlenstoffatome im Verhältnis zu Wasserstoff und C (%) die Konzentration von Sauerstoffatomen im Verhältnis zum Wasserstoff ist.

2. Verfahren nach Anspruch 1, worin die Kohlenstoffatome im Reaktionsgas 99,9 % oder mehr an $^{12}C$ oder $^{13}C$ umfassen.

3. Verfahren nach Anspruch 2, worin die Kohlenstoffatome im Reaktionsgas 99,9 % oder mehr an $^{12}C$ umfassen.

4. Verfahren nach Anspruch 1, worin wenigstens eine aus der aus Methan, Ethan, Acetylen, einem Alkohol, einem Keton, Kohlenmonoxid und Kohlendioxid bestehenden Gruppe ausgewählte Verbindung als Kohlenstoffquelle verwendet wird.

5. Verfahren nach Anspruch 1, worin die CVD-Methode eine Heizfaden-CVD-Methode ist und der Faden ein 99,9 % oder mehr an $^{12}C$ oder $^{13}C$ enthaltender Kohlenstoff-Faden ist.

6. Synthetischer Diamant, der 20 ppm oder weniger an Stickstoffatomen enthält, wobei das Verhältnis der Peakhöhen von nicht-diamantartigem Kohlenstoff zu Diamant im Ramanspektrum nicht größer als 0,07 ist, **gekennzeichnet** durch einen Wärmeleitfähigkeitskoeffizienten von wenigstens 25 W/cmK.

7. Synthetischer Diamant nach Anspruch 6, wobei der Diamant 5 ppm oder weniger an Stickstoffatomen enthält.

8. Synthetischer Diamant nach Anspruch 6, wobei der Kohlenstoff wenigstens 99,9 % an $^{12}C$ oder $^{13}C$ umfaßt und der Stickstoffgehalt kleiner ist als 20 ppm.

## Revendications

1. Procédé de production de diamant par un procédé de CVD, comprenant la décomposition et la réaction d'un gaz réactif,
dans lequel $\alpha$ est inférieur ou égal à 13 et B est supérieur ou égal à 20,
B (ppm) étant la concentration de l'azote gazeux par rapport à la totalité du gaz réactif et $\alpha$ étant défini par l'équation :

$$\alpha = \sqrt{B}(A - 1,2C)$$

A (%) étant la concentration des atomes de carbone par rapport à l'hydrogène gazeux et C (%) étant la concentration des atomes d'oxygène par rapport à l'hydrogène gazeux.

2. Procédé selon la revendication 1, dans lequel les atomes de carbone du gaz réactif contiennent au moins 99,9 % de $^{12}C$ ou $^{13}C$.

3. Procédé selon la revendication 2, dans lequel les atomes de carbone du gaz réactif contiennent au moins 99,9 % de $^{12}C$.

4. Procédé selon la revendication 1, dans lequel un composé au moins choisi dans le groupe formé par méthane, l'éthane, l'acétylène, un alcool, une cétone, l'oxyde de carbone et l'anhydride carbonique est utilisé comme source de carbone.

5. Procédé selon la revendication 1, dans lequel le procédé de CVD est un procédé de CVD à filament chaud et le filament est un filament de carbone contenant au moins 99,9 % de $^{12}$C ou $^{13}$C.

6. Diamant synthétique contenant au maximum 20 ppm d'atome d'azote, dans lequel le rapport des hauteurs de crête du carbone autre que le diamant et du diamant dans le spectre Raman ne dépasse pas 0,07, caractérisé par un coefficient de conductibilité thermique au moins égal à 25 W/cm.K.

7. Diamant synthétique selon la revendication 6, dans lequel le diamant contient au maximum 5 ppm d'atomes d'azote.

8. Diamant synthétique selon la revendication 6, dans lequel le carbone contient au moins 99,9 % de $^{12}$C ou $^{13}$C, et la teneur en azote est inférieure à 20 ppm.

Fig.1  (C=0/ O₂ = 0%)

Fig. 2 (C=1.0 / $O_2$ = 0.5%)

Fig.3 (C=4.0/ $O_2$ = 2,0%)